# EUROPÄISCHE PATENTSCHRIFT

(11) **EP 2 800 153 B1**
(45) Veröffentlichungstag und Bekanntmachung des Hinweises auf die Patenterteilung: **29.08.2018**
(21) Anmeldenummer: 14166328.6
(22) Anmeldetag: 29.04.2014
(51) Int. Cl.: H01L 33/54

(54) **LED-Modul mit hochreflektierender Fläche**
LED module with a highly reflective surface
Module à DEL doté d'une surface fortement réfléchissante

(30) Priorität: 30.04.2013 DE 102013207960; 05.08.2013 DE 102013215326
(43) Veröffentlichungstag der Anmeldung: 05.11.2014
(73) Patentinhaber: Tridonic Jennersdorf GmbH, 8380 Jennersdorf (AT)
(72) Erfinder: Gumhold, Jürgen, 8380 Jennersdorf (AT); Wimmer, Florian, 8380 Jennersdorf (AT)
(74) Vertreter: Rupp, Christian

(56) Entgegenhaltungen:
- WO-A2-2007/139780
- JP-A- 2013 030 572
- US-A1- 2007 029 569
- US-A1- 2009 146 155
- US-A1- 2010 025 699
- US-A1- 2010 177 258

## Beschreibung

Die vorliegende Erfindung betrifft ein LED-Modul sowie ein Herstellungsverfahren des erfindungsgemäßen LED-Moduls. Insbesondere weist die vorliegende Erfindung ein LED-Modul auf, das eine hochreflektierende Fläche umfasst, auf dem ein Dispenstropfen über einem oder mehreren LED-Chips angeordnet ist.

Aus dem Stand der Technik sind LED-Module bekannt, bei denen wenigstens ein LED-Chip auf einer Basisplatte des LED-Moduls angeordnet ist und mit einem Dispenstropfen ("Globe-top") überdeckt ist. In der Regel ist dabei der wenigstens eine LED-Chip in einer Aushöhlung in der Basisplatte angeordnet, wobei die Aushöhlung typischerweise reflektierende Seitenwände aufweist. Diese LED-Module ("LED in cavity") sind allerdings relativ teuer in der Herstellung. Ferner besteht bei allen bekannten LED-Modulen der Bedarf einer Verbesserung der thermischen Anbindung der LED-Chips. Zudem besteht der Bedarf einer Verminderung von Lichtverlusten aufgrund von Absorption durch die Teilbereiche, die um den LED-Chip herum angeordnet sind.

Die vorliegende Erfindung hat zur Aufgabe, den bekannten Stand der Technik zu verbessern. Insbesondere sollen die oben genannten Nachteile des Standes der Technik zumindest teilweise behoben werden. Eine Aufgabe der vorliegenden Erfindung ist es, ein LED-Modul bereitzustellen, dessen LED-Chips besser thermisch angebunden sind. Eine weitere Aufgabe der vorliegenden Erfindung ist es, ein LED-Modul bereitzustellen, für das Lichtverluste aufgrund von Absorption durch die umliegenden Bereiche des LED-Chips verringert sind. Ferner soll ein LED-Modul bereitgestellt werden, das eine erhöhte Lichtabgabe bei gleichzeitig verringerten Prozesskosten aufweist. Das LED-Modul der vorliegenden Erfindung soll ferner möglichst variabel einsetzbar und ansteuerbar sein. Ferner soll das LED-Modul dazu geeignet sein, Lichtfelder oder LED-Cluster zu bilden.
Die vorliegende Erfindung löst die oben genannten Aufgaben gemäß ihren unabhängigen Ansprüchen. Der Kern der Erfindung ist dabei eine Kombination eines Dispenstropfens mit einer hochreflektierenden Fläche des LED-Moduls. Die abhängigen Ansprüche bilden den Kerngedanken der vorliegenden Erfindung auf vorteilhafte Art und Weise weiter. Patentanmeldung JP2013030572 offenbart ein LED Modul aufweisend eine reflektierende Oberfläche welche das Substrat bedeckt und auf welcher ein LED Chip angeordnet ist. Ein Halteelement ragt vertikal empor aus der reflektierenden Oberfläche und weist eine Schicht auf welche flüssiges Harz abweist wenn es im Dispensverfahren auf den LED Chip aufgetragen wird.

Patentanmeldung US20070029569 offenbart eine ähnliche Struktur mit Bonddrähte.

Patentanmeldung US2010177258 offenbart eine LED-Plattform mit mehreren LEDs und Dispensertropfen. Die Kontaktierung der LED Chips erfolgt rückseitig. US20090146155 offenbart eine ähnliche Struktur, bei der die Bonddrähte innerhalb des Dispenstropfens an Bondfläche befestigt sind. Die vorliegende Erfindung betrifft insbesondere ein LED-Modul, das aufweist, eine spiegelnde Fläche, wenigstens einen LED-Chip, der auf der spiegelnden Fläche angeordnet ist, und wenigstens einen Dispenstropfen, der auf die spiegelnde Fläche aufgebracht ist und den wenigstens einen LED-Chip überdeckt.
Die spiegelnde Fläche ist aus einem hochreflektierenden Material hergestellt. Die thermische Anbindung des wenigstens einen LED-Chips wird durch die spiegelnde Fläche deutlich verbessert. Zudem wird durch die reflektierende Fläche ein erhöhter Lichtoutput des LED-Moduls insgesamt erreicht. Gleichzeitig werden die Prozesskosten zur Herstellung des LED-Moduls gesenkt, da ein Standarddispens zum Aufbringen des Dispenstropfens eingesetzt werden kann. Insgesamt stellt deshalb das erfindungsgemäße LED-Modul eine hochreflektierende Lösung mit gleichzeitig optimiertem Thermomanagement dar.

Vorzugsweise weist die spiegelnde Fläche einen Reflexionsgrad von 94% oder mehr, mehr bevorzugt von 95% oder mehr, besonders bevorzugt von 97% oder mehr auf.

Der hohe Reflexionsgrad der spiegelnden Fläche garantiert eine besonders hohe und effiziente Lichtabgabe des LED-Moduls.

Unter dem wenigstens einen Dispenstropfen ist wenigstens ein Bonddraht angeordnet.

Unter dem wenigstens einen Dispenstropfen ist ferner wenigstens eine Bondfläche zur Kontaktierung des wenigstens einen LED-Chips mit wenigstens einem Bonddraht angeordnet.

Die wenigstens eine Bondfläche ist von außerhalb des wenigstens einen Dispenstropfens durch wenigstens einen elektrisch leitenden Finger kontaktiert.

Mehrere LED-Chips können unter dem Dispenstropfen hindurch ankontaktiert sein. Von außen kann durch entsprechende Kontaktierung der leitenden Finger eine gewünschte Ansteuerung der LED-Chips vorgenommen werden. Durch den erfindungsgemäßen Kontaktierungsmechanismus können verschiedene Kontaktierungen der LED-Chips ohne erneutes Bonden der LED-Chips und ohne Eingriff unter dem Dispenstropfen realisiert werden.

Vorzugsweise sind zwei oder mehr elektrisch leitende Finger auf Quadranten der spiegelnden Fläche verteilt.

Vorzugsweise sind mehrere LED-Chips unter dem wenigstens einen Dispenstropfen angeordnet und vorzugsweise dazu ausgelegt, unterschiedliche Lichtspektren abzugeben.

Das erfindungsgemäße LED-Modul ist dadurch geeignet, Mischlicht aus den unterschiedlichen Lichtspektren, beispielsweise Weißlicht, abzugeben.

Vorzugsweise sind die mehreren LED-Chips unter dem Dispenstropfen in einer Serien- und/oder Reihenschaltung mittels der elektrisch leitenden Finger miteinander verschaltet.

Die vorliegende Erfindung ermöglicht es, Standardprozesse auf innovativen reflektierenden Materialien einzusetzen. Dadurch können die Eigenschaften des LED-Moduls, zum Beispiel die Gesamtlichtabgabe und die thermische Anbindung der LED-Chips, ohne erhöhte Prozesskosten verbessert werden. Unter dem Dispenstropfen kann beispielweise durch entsprechendes Verschalten der LED-Chips eine LED-Gruppe oder ein LED-Cluster gebildet werden.

Vorzugsweise entspricht die Außenkontur der spiegelnde Fläche der Außenkontur des wenigstens einen Dispenstropfens.

Damit ergibt sich vorzugsweise eine Art spiegelnder Rahmen um die Kontur des Dispenstropfens. Dies bewirkt unter anderem eine gleichmäßige Lichtabgabe.

Vorzugsweise sind mehrere punktförmige Dispenstropfen auf der spiegelnden Fläche angeordnet, um mehrere punktförmige Lichtquellen zu bilden.

Die einzelnen Punktlichtquellen können dabei Licht unterschiedlicher Wellenlänge abgeben, um ein Mischlicht zu erzeugen. Die punktförmigen Lichtquellen können gleich groß oder unterschiedlich groß sein, um die einzelnen Wellenlängen des Mischlichts zu gewichten.

Vorzugsweise spannen die mehreren punktförmigen Lichtquellen ein Lichtfeld auf.

Das Lichtfeld kann flächig oder linienförmig sein, je nach Anordnung der Punktlichtquellen. Vorzugsweise sind die optischen Eigenschaften des Materials der mehreren Dispenstropfen unterschiedlich, um beispielweise unterschiedlich farbige Lichtquellen in einem flächigen oder linienförmigen Lichtfeld miteinander zu kombinieren. Somit kann beispielsweise ein Weißlicht erzeugendes LED-Modul gebildet werden.

Vorzugsweise ist das gesamte Lichtfeld auf der spiegelnden Fläche angeordnet.

Der Lichtoutput des gesamten Lichtfelds kann so erhöht werden. Auf der vordefinierten spiegelnden Fläche können somit beispielsweise LED-Cluster gebildet werden. Die ist kostengünstiger als die "LED in cavity"-Methode zum Bilden von LED-Clustern. Außerdem ist ein Nacharbeiten im Vergleich zu herkömmlichen LED-Clustern einfacher möglich, da die Lichtabstrahlflächen separiert sind. Es können auch mehrere, beispielweise flächige und/oder linienförmige, Lichtfelder auf der spiegelnden Fläche gebildet sein. Vorzugsweise ist vor den mehreren punktförmigen Lichtquellen in deren Abstrahlrichtung eine Streuscheibe angeordnet.

Die Streuscheibe dient zum Vermischen des Lichts aus den unterschiedlichen Punktlichtquellen des Lichtfeldes, um ein besonders homogenes Mischlicht zu erzeugen. Die Streuscheibe kann dabei auch Lichtkonversionsstoffe (bspw. einen Phosphor oder Leuchtstoff) enthalten, um das Licht aus den Punktlichtquellen spektral zu beeinflussen. Wenn die Punktlichtquellen unterschiedliche Lichtspektren abgeben, kann die Streuscheibe auch derart ausgelegt sein, dass sie nur Licht aus bestimmten Punktlichtquellen streut und/oder spektral beeinflusst.

Vorzugsweise ist wenigstens ein Dispenstropfen linienförmig, um wenigstens eine linienförmige Lichtquelle zu bilden.

Das LED-Modul ist dann beispielweise gut zum Bilden von Leuchtbuchstaben oder -Schriften geeignet.

Vorzugsweise ist wenigstens eine Durchkontaktierung um die spiegelnde Fläche herum und außerhalb der Kontur der spiegelnden Fläche angeordnet.

Das erfindungsgemäße LED-Modul ist vorzugsweise in eine Spot- und Downlight Anwendung einsetzbar.

Die vorliegende Erfindung betrifft ferner ein Verfahren zum Herstellen eines LED-Moduls, das aufweist: Bilden einer spiegelnden Fläche, Anordnen von wenigstens einem LED-Chip auf der spiegelnden Fläche, und Überdecken des wenigstens einen LED-Chips mit wenigstens einem Dispenstropfen, der auf die spiegelnde Fläche aufgebracht wird.

Das erfindungsgemäße Verfahren ist besonders kostengünstig auszuführen, da ein Standarddispens eingesetzt werden kann. Das Verfahren erzielt ein LED-Modul mit besonders effizienter Lichtabgabe und optimiertem Thermomanagment.

Im Folgenden wird die vorliegende Erfindung im Detail mit Bezug auf die beigefügten Figuren beschrieben.
Fig. 1 zeigt eine erste Ausführungsform eines LED-Moduls der vorliegenden Erfindung.
Fig. 2 zeigt die spiegelnde Fläche des LED-Moduls der ersten Ausführungsform der vorliegenden Erfindung.
Fig. 3 zeigt Schnittansichten des LED-Moduls der ersten Ausführungsform der vorliegenden Erfindung.
Fig. 4 zeigt eine zweite Ausführungsform eines LED-Moduls der vorliegenden Erfindung.
Fig. 5 zeigt eine dritte Ausführungsform eines LED-Moduls der vorliegenden Erfindung.
Fig. 6 zeigt eine vierte Ausführungsform eines LED-Moduls der vorliegenden Erfindung.
Fig. 7 zeigt eine fünfte Ausführungsform eines LED-Moduls der vorliegenden Erfindung.
Fig. 8 zeigt die spiegelnde Fläche des LED-Moduls der fünften Ausführungsform der vorliegenden Erfindung.
Fig. 9 zeigt Schnittansichten des LED-Moduls der fünften Ausführungsform der vorliegenden Erfindung.
Fig. 10 zeigt eine sechste Ausführungsform eines LED-Moduls der vorliegenden Erfindung.
Fig. 11 zeigt eine siebte Ausführungsform eines LED-Moduls der vorliegenden Erfindung.
Fig. 12 zeigt weitere Ausführungsformen eines LED-Moduls der vorliegenden Erfindung.

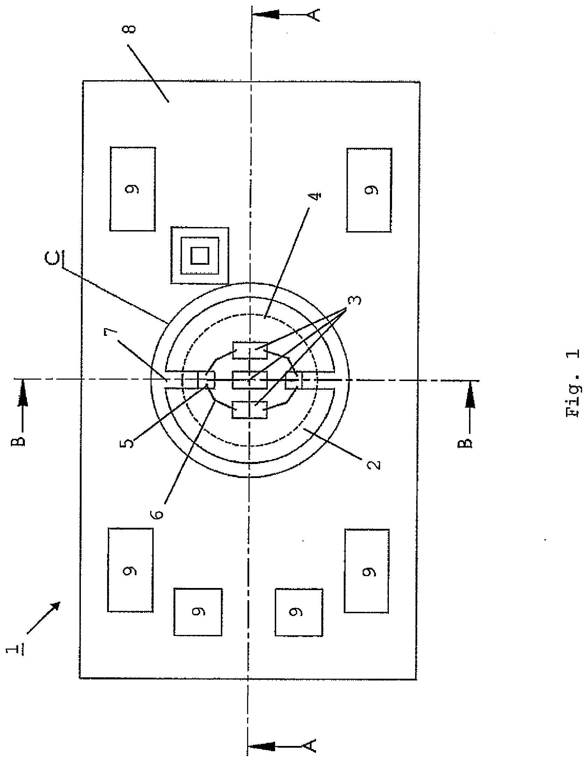

Fig. 1 zeigt, dass das erfindungsgemäße LED-Modul 1 eine Basisplatte 8 aufweist, auf der vorzugsweise alle Komponenten des LED-Moduls 1 angeordnet sind. Die Komponenten sind beispielweise aufgelötet, aufgesteckt oder aufgeklebt. Die Basisplatte 8 kann beispielsweise eine bekannte Leiterplatte sein, etwa eine gedruckte Leiterplatte (Printed Circuit Board, PCB).

Auf der Basisplatte 8 können zum einen elektrische Komponenten 9 angeordnet sein, die zum Ansteuern von LED-Chips 3 des LED-Moduls 1 ausgelegt sind. Elektrische Komponenten sind beispielweise Steuereinheiten, Mikrocontroller oder passive Elemente wie Widerstände, Induktivitäten oder Kapazitäten. Ferner können auch andere Komponenten 9 auf der Basisplatte 8 vorhanden sind, die beispielweise zur Abführung von Wärme von der Basisplatte 8 des LED-Moduls 1 dienen. Diese Komponenten 9 können Kühlkörper oder Kühlfinnen sein.

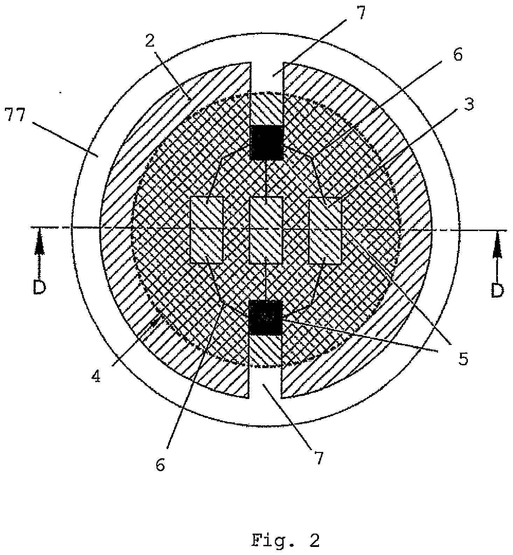

Zum anderen ist auf der Basisplatte 8 des LED-Moduls 1 auch eine spiegelnde Fläche 2 angeordnet. Die spiegelnde Fläche 2 hat vorzugsweise einen Reflexionsgrad von 94% oder mehr, mehr bevorzugt 95% oder mehr, noch mehr bevorzugt 97% oder mehr. Die spiegelnde Fläche 2 kann beispielsweise hochreflektierendes Aluminium (oder Silber, oder deren Verbindungen) umfassen. Oxid- und/oder PolymerSchichten können auf eine Aluminiumfläche aufgebracht sein. Eine für die spiegelnde Fläche der vorliegenden Erfindung geeignete hochreflektierende Aluminiumoberfläche wird beispielweise von der Firma Alanod hergestellt. Die spiegelnde Fläche 2 kann aber auch aus einem anderen geeigneten Material bestehen. Beispielweise kann die spiegelnde Fläche 2 aus einem hochreflektierenden Lack bestehen, der durch bekannte Techniken auf die Basisplatte 8 aufgebracht wird. Vorzugsweise weist die spiegelnde Fläche 2 eine runde, etwa ovale oder ellipsenförmige, noch mehr bevorzugt eine kreisförmige Außenkontur auf, wie in Fig. 2 gezeigt. Die spiegelnde Fläche 2 kann auf der Basisplatte 8 ausgebildet sein, bspw. durch Dämmen und Füllen mit dem hochreflektierenden Material. Alternativ kann die spiegelnde Fläche 2 in die Basisplatte 8 eingelassen sein, so dass sie eine bündige Oberfläche mit der Basisplatte 8 aufweist.

Die Basisplatte 8 ist vorzugsweise eine mehrschichtige Platte, die eine Leiterplatte (PCB) als obere Schicht und eine Metallschicht/Metallplatte als untere Schicht umfasst. Die Kante der Leiterplatte kann bspw. auch hochreflektierend ausgebildet sein.

Auf der spiegelnden Fläche 2 ist wenigstens ein LED-Chip 3 angeordnet. In Fig.1 ist zu sehen, dass drei LED-Chips 3 auf der spiegelnden Fläche 2 angeordnet sind. Ein LED-Chip 3 kann eine LED sein, oder aus mehreren LEDs, bspw. einer LED-Strecke, bestehen. Ferner ist auf der spiegelnden Fläche 2 wenigstens ein Dispenstropfen 4 ("Globe-top") angeordnet, der die LED-Chips 3 auf der spiegelnden Fläche 2 überdeckt. Der Dispenstropfen 4 ist vorzugsweise zumindest teilweise transparent. Der Dispenstropfen 4 kann lumineszierende Teilchen und/oder lichtstreuende Partikel (bspw. Partikel basierend auf SiO₂, TiO₂, BaTiO₃ usw.) umfassen. Ferner können lumineszierende organische und/oder anorganische Materialien (bspw. Leuchtstoffe, Farbstoffe, Quantendots usw.) in den Dispenstropfen 4 eingebettet sein.

Bei der vorliegenden Erfindung kann der Dispenstropfen 4 mit herkömmlichen Standarddispensprozessen hergestellt sein. Zur Bildung des Dispenstropfens 4 wird vorzugsweise ein geeignetes transparentes Material auf die spiegelnde Fläche 2 getropft und dann ausgehärtet. Dadurch können die LED-Chips 3 auf der spiegelnden Fläche 2 fixiert werden. Die LED-Chips 3 können aber bereits zuvor auf der spiegelnden Fläche 2 befestigt worden sein.

Die vorliegende Erfindung erreicht mit der oben beschriebenen Anordnung, dass zum einen die thermische Anbindung der LED-Chips 3 aufgrund der spiegelnden Fläche 2 verbessert wird. Zum anderen wird auch der Gesamtlichtoutput des LED-Moduls 1 durch die spiegelnde Fläche 2 erhöht. Außerdem können bekannte Standardprozesse auf dem hochreflektierenden Material der spiegelnden Fläche 2 verwendet werden, so dass die Prozesskosten zur Herstellung des erfindungsgemäßen LED-Moduls 1 niedrig sind.

Fig. 1 zeigt weiter, dass wenigstens eine Bondfläche 5 zur Kontaktierung des wenigstens einen LED-Chips 3 unter dem Dispenstropfen 4 angeordnet ist. Vorzugsweise ist jede Bondfläche 5 eine Gold-Bondfläche. Der eine oder die mehreren LED-Chips 3 unter dem Dispenstropfen 4 können mittels Bonddrähten 6, vorzugsweise mittels Gold-Bonddrähten, über die Bondflächen 5 kontaktiert werden. Dabei ist es möglich sowohl Seriell- als auch Parallel-Schaltungen aus verschiedenen LED-Chips 3 unter dem Dispenstropfen 4 zu erzeugen. Fig. 1 zeigt beispielsweise wie drei LED-Chips 3 unter dem Dispenstropfen 4 parallel zwischen zwei Bondflächen 5 geschaltet sind. Die Bondflächen 5 (und optional der die Bondflächen 5 umgebende Bereich der spiegelnden Fläche 5) können zusätzlich nach dem Bonden (also nach dem Anbringen der Bonddrähte) mit einer reflektierenden Schicht, vorzugsweise einer weißen Schicht, abgedeckt werden.
Fig. 1 zeigt weiter, dass jede Bondfläche 5 durch einen leitenden Finger 7 von außerhalb des Dispenstropfens 4 ankontaktiert ist. Die LED-Chips 3 unter dem Dispenstropfen 4 können also gesamtheitlich durch die elektrisch leitenden Finger 7 angesteuert werden.

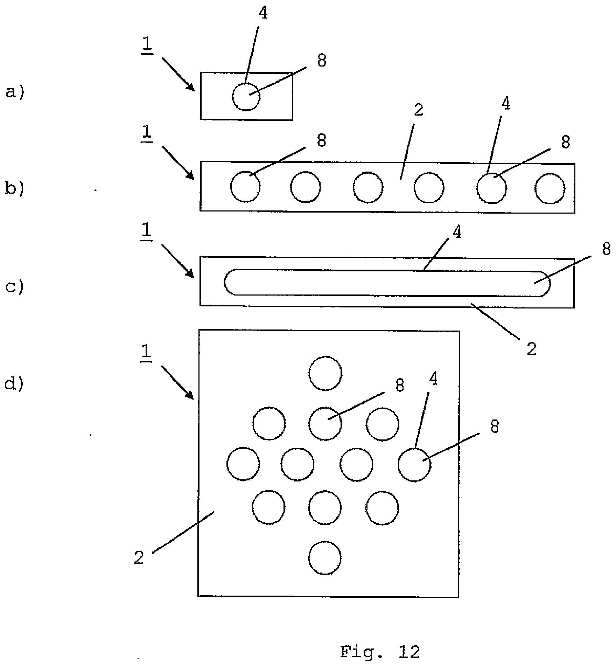

Fig. 2 zeigt eine vergrößerte Ansicht der spiegelnden Fläche 2 des LED-Moduls aus Fig. 1. Die leitenden Finger 7 können entweder auch spiegelnd (hochreflektierend) sein, bspw. aus demselben Material wie die spiegelnde Fläche 2 hergestellt, oder können aus einem anderen nicht hochreflektierenden Material gebildet sein. Die leitenden Finger 7 können miteinander verbunden sein, beispielweise durch ein die spiegelnde Fläche 2 umlaufendes Verbindungsstück 77. Die Finger 7 können aber auch unverbunden sein.
Ferner ist in Fig. 2 gezeigt, dass vorzugsweise die Außenkontur der spiegelnden Fläche 2 der Außenkontur des Dispenstropfens 4 entspricht, so dass sich eine Art spiegelnder Rahmen um die Außenkontur des Dispenstropfens 4 ergibt. Dabei ist die Außenkontur der spiegelnden Fläche 2 größer als die Außenkontur des Dispenstropfens 4. Die spiegelnde Fläche 2 ist also vorzugsweise deshalb rund oder kreisförmig, da in der Regel der Dispenstropfen 4 rund oder kreisförmig ist. Der Dispenstropfen 4 muss aber nicht zwangsläufig eine kreisförmige Außenkontur aufweisen, sondern es können - wie in Fig. 12c gezeigt und unten genauer beschrieben - auch streifenförmige Dispenstropfen 4 erzeugt werden. Vorzugsweise entspricht ferner die Außenkontur des Verbindungselements 77 der Außenkontur der spiegelnden Fläche 2.

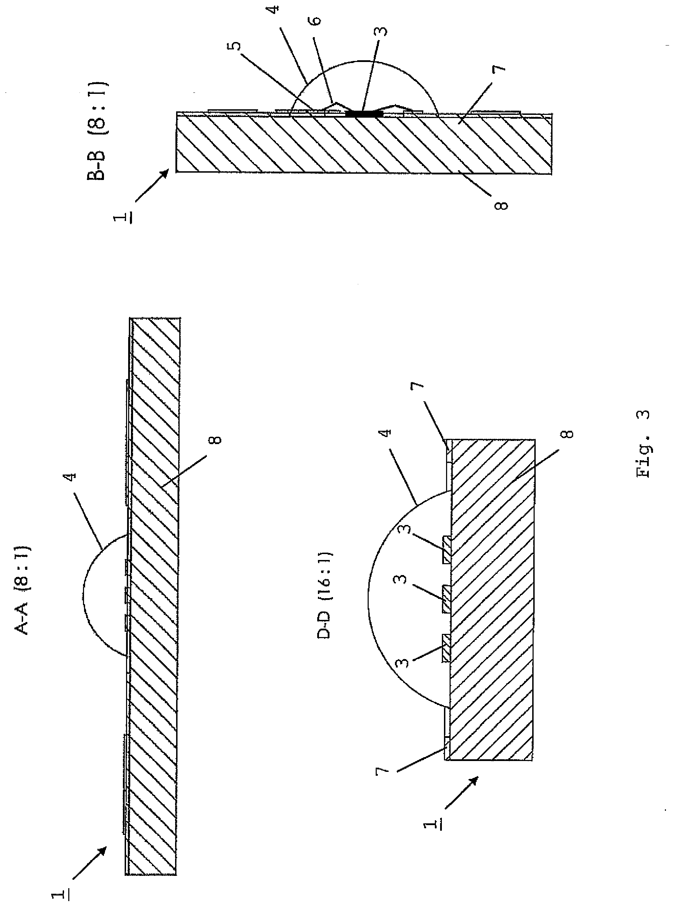

Fig. 3 zeigt Schnittansichten des LED-Moduls 1 bezüglich der Fig. 1 (d.h. die Schnitte A-A und B-B) sowie der Fig. 2 (d.h. den Schnitt D-D). Dabei ist zu sehen, wie der Dispenstropfen 4 die mehreren LED-Chips 3 überdeckt und wie die LED-Chips 3 unter dem Dispenstropfen 4 durch die Bonddrähte 6 ankontaktiert und/oder miteinander kontaktiert sind. Die leitenden Finger 7 können außerhalb des Dispenstropfens ankontaktiert und zum Beispiel mit elektrischen Steuerkomponenten verbunden werden, um die LED-Chips 3 im inneren des Dispenstropfens 4 zu steuern. Es wird also eine elektrische Anbindung an die LED-Chips 3 nach außen aus dem Dispenstropfen 4 herausgeführt.

Die LED-Chips 3 unter dem Dispenstropfen 4 können jeweils eine LED oder mehrere LEDs umfassen (bspw. im blauen, grünen, und/oder im roten Farbbereich bzw. Farbspektrum emittierende LEDs). Mehrere LEDs oder LED-Chips 3 unter dem Dispenstropfen 4 können dabei Licht aus unterschiedlichen Spektren abgeben, so dass insgesamt aus dem Dispenstropfen 4 ein Mischlicht, vorzugsweise ein Weißlicht, abgegeben wird. Es kann dabei auch jeder einzelne LED-Chip 3 unter dem Dispenstropfen 4 dazu geeignet sein, Weißlicht abzugeben. Beispielweise kann jeder LED-Chip 3 durch die Kombination einer blauen LED und eines entsprechenden Leuchtstoffs, bspw. einem Leuchtstoff der ein gelbes, gelb-grünes oder rotes Sekundärlichtspektrum erzeugt, bestehen. Auch kann jeder Dispenstropfen 4 mit einem Leuchtstoffmaterial bzw. einem Lichtkonversionsmaterial versehen sein. Beispielweise ist dieses Material in das vorzugsweise transparente Material des Dispenstropfens 4 eingebettet oder als Schicht auf diesen aufgebracht. Ein Beispiel für ein Lichtkonversionsmaterial ist ein Phosphor. Der Leuchtstoff oder das Lichtkonversionsmittel kann als Pulver, als Partikel, als Cluster oder gelöst in dem Dispenstropfen 4 vorliegen und kann das von dem wenigstens einen LED-Chip 3 abgegebene Licht spektral beeinflussen, d.h. dessen Lichtfarbe und/oder Lichtfarbtemperatur verändern. Der Dispenstropfen 4 kann also ein zusätzliches Lichtspektrum zu den von den LED-Chips 3 abgegebenen Lichtspektren erzeugen, um ein homogeneres Mischlicht, wie vorzugsweise ein Weißlicht, zu erzeugen.

Durch unterschiedliche Kontaktierung mittels der leitfähigen Finger 7 können Serien- und/oder Reihenschaltungen der LED-Chips 3 unter dem Dispenstropfen 4 erzielt werden.

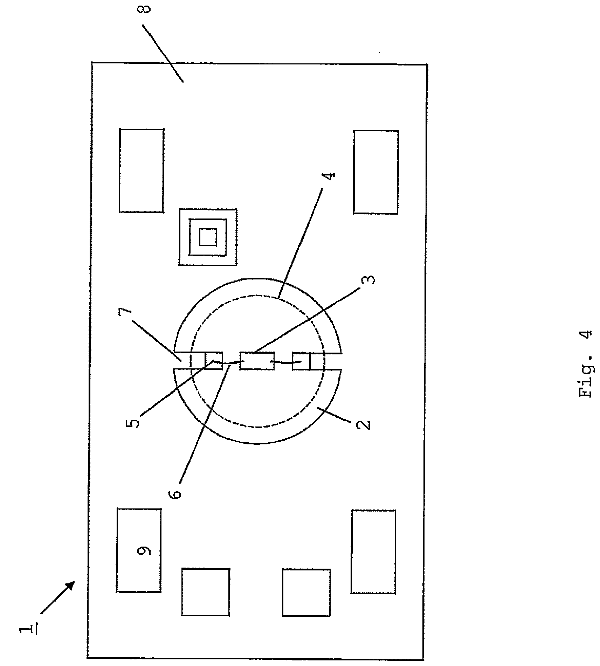

Wie bereits beschrieben zeigt die Fig. 1 eine Parallelschaltung von drei LED-Chips 3 unter dem Dispenstropfen 4. Die Fig. 4 zeigt eine einfachere Version des LED-Moduls 1, bei der nur ein LED-Chip 3 unter dem Dispenstropfen 4 mit zwei leitenden Fingern 7 angesteuert wird.

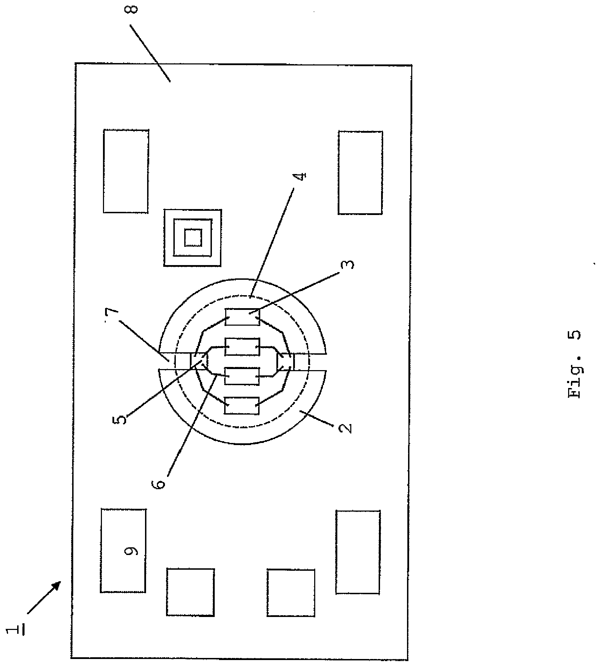

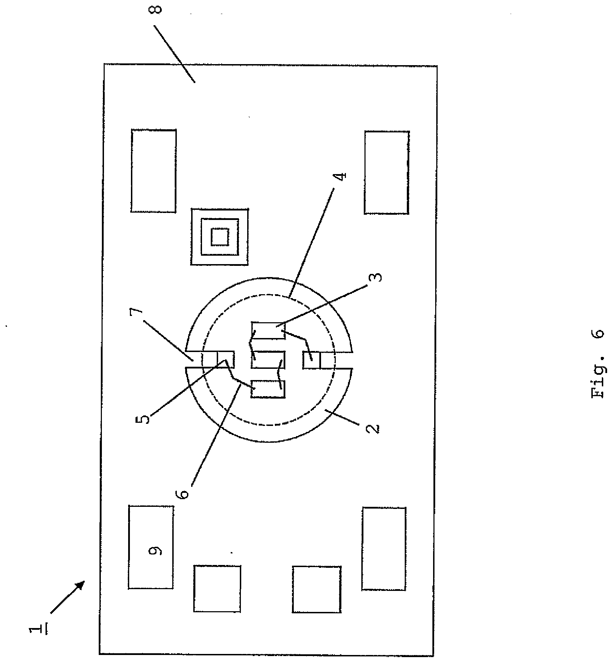

Fig. 5 zeigt eine Ausführungsform des LED-Moduls 1, bei der vier LED-Chips 3 parallel unter dem Dispenstropfen 4 verschaltet sind. Fig. 6 zeigt eine Ausführungsform des LED-Moduls 1 mit drei LED-Chips 3 unter dem Dispenstropfen 4, die aber im Gegensatz zu der in Fig. 1 gezeigten Ausführungsform seriell miteinander verschaltet sind.

Vorzugsweise sind zwei, drei oder vier oder sogar mehr elektrisch leitenden Finger 7 auf Quadranten der spiegelnden Fläche 2 verteilt. In den Fig. 1-6 ist gezeigt, dass zwei spiegelnde Finger 7 auf die Quadranten bzw. die Hälften der spiegelnden Fläche 2 verteilt sind.

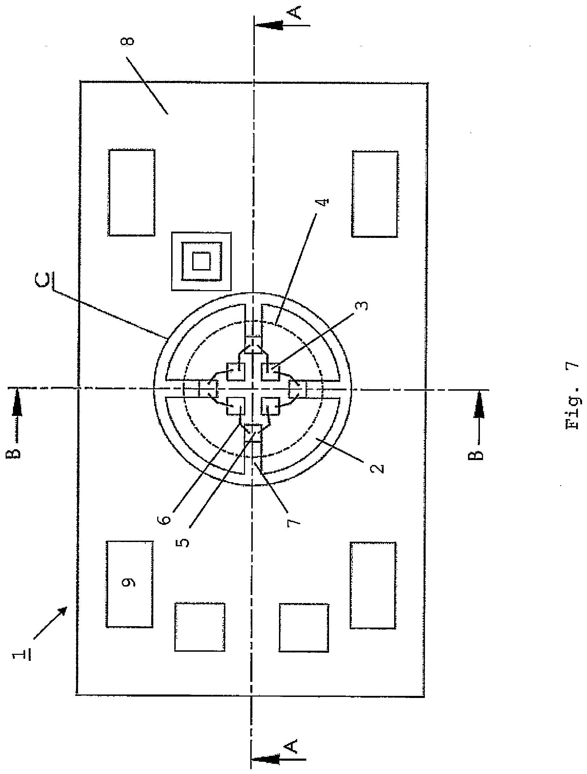

Fig. 7 zeigt eine weitere Ausführungsform eines erfindungsgemäßen LED-Moduls 1, bei der vier elektrisch leitende Finger 7 auf die Quadranten der spiegelnden Fläche 2 verteilt sind. In Fig. 7 sind vier LED-Chips 3 unter dem Dispenstropfen 4 angeordnet. Diese sind derart kontaktiert, dass eine Serien- und Reihenschaltung der LED-Chips 3 unter dem Dispenstropfen 4 realisierbar ist.

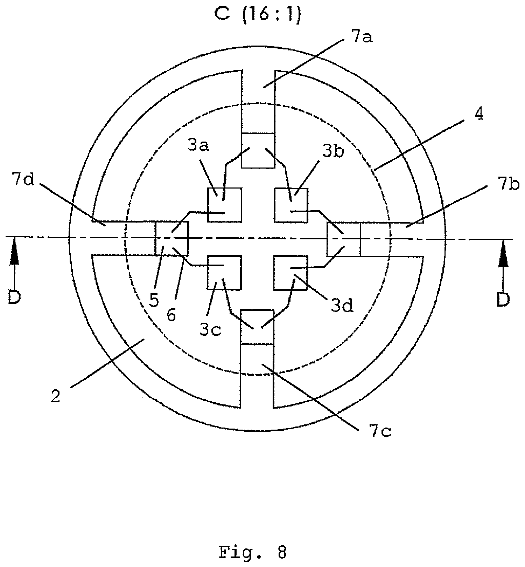

Fig. 8 zeigt wiederum eine vergrößerte Ansicht der spiegelnden Fläche 2 des LED-Moduls 1 der Fig. 7. Es ist zu sehen, dass die spiegelnde Fläche 2 kreisförmig ist und in jedem Quadranten der Kreisfläche ein elektrisch leitender Finger 7a, 7b, 7c bzw. 7d von außen in den Dispenstropfen 4 hineingeführt ist. Dort ist jeder elektrisch leitende Finger 7a, 7b, 7c bzw. 7d mit einer Bondfläche 5 verbunden, von der aus die LED-Chips 3 mittels Bonddrähten 6 kontaktiert sind. Die LED-Chips 3 sind derart kontaktiert, dass jeweils zwei LED-Chips 3 entweder seriell und/oder parallel über die leitenden Finger 7a, 7b, 7c bzw. 7d steuerbar sind.

Beispielweise können über die elektrisch leitenden Finger 7a und 7c die LED-Chips 3a und 3c in Serie angesteuert werden, genau wie die LED-Chips 3b und 3d. Die jeweiligen Serienschaltungen können außerdem parallel zueinander betrieben werden. Über die elektrisch leitenden Finger 7b und 7d können bspw. die Chips 3a und 3b bzw. 3c und 3b in Serie angesteuert werden. Diese Serienschaltungen können zudem wiederum parallel betrieben werden. Es sind aber auch kompliziertere Ansteuerungsmöglichkeiten mit zwei oder drei oder vier elektrisch leitenden Fingern 7a, 7b, 7c, 7d denkbar. Das LED-Modul 1 der vorliegenden Erfindung ermöglicht so einen äußerst flexiblen Einsatz durch eine variable Ansteuerung der LED-Chips 3, ohne dass ein Eingriff unter dem Dispenstropfen 4 nötig ist.

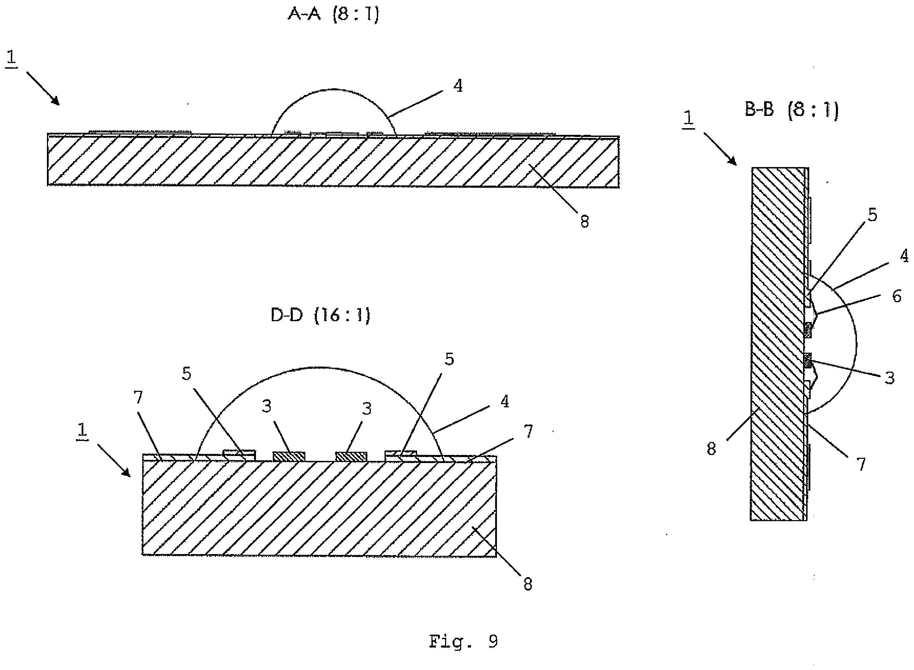

Fig. 9 zeigt wiederum Schnittansichten des LED-Moduls 1. Dabei ziehen sich die Schnittansichten auf Fig. 7 (d.h. Schnitte A-A und B-B) sowie Fig.8 (d.h. Schnitt D-D).

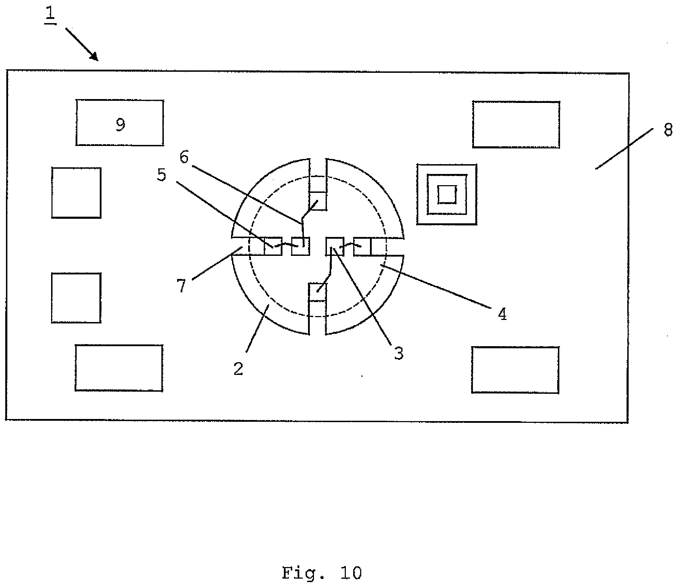

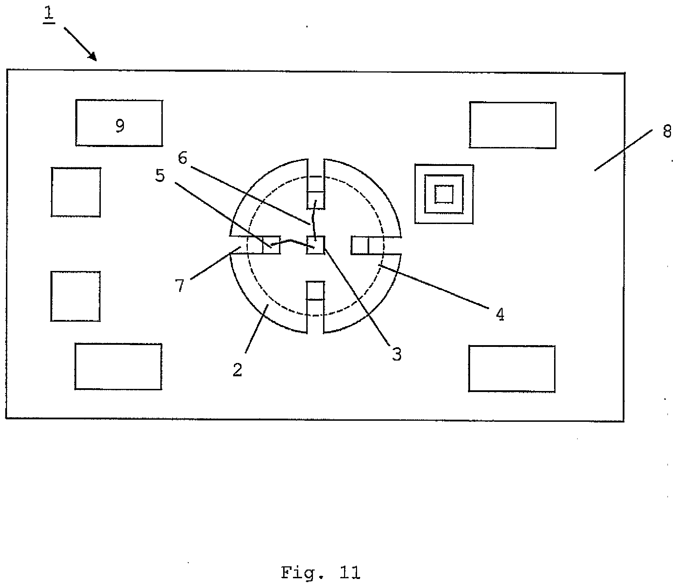

Fig. 10 zeigt eine weitere Ausführungsform des erfindungsgemäßen LED-Moduls 1 mit vier elektrisch leitenden Fingern 7. In dieser Ausführungsform sind zwei LED-Chips 3 unter dem Dispenstropfen 4 angeordnet, wobei jeweils zwei elektrisch leitende Finger 7 einen LED-Chip 3 ansteuern. Fig. 11 zeigt eine Ausführungsform mit vier elektrisch leitenden Fingern 7, aber mit nur einem LED-Chip 3.

Bei allen Ausführungsformen gemäß der Fig. 1-11 ist es auch möglich, dass die Bondflächen 5 um die spiegelnde Fläche 2 herum außerhalb der Kontur der spiegelnden Fläche 2 angeordnet sind und dafür keine leitenden Finger 7 vorhanden sind.

Fig. 12 zeigt weitere vorteilhafte Ausführungsformen des LED-Moduls 1 der vorliegenden Erfindung. Fig. 12a zeigt ein LED-Modul 1 mit einem einzelnen Dispenstropfen 4, unter dem wenigstens ein LED-Chip 3 angeordnet ist. Der Dispenstropfen 4 bildet eine Punktlichtquelle 8.

Fig. 12b zeigt ein LED-Modul 1, bei dem mehrere Dispenstropfen 4 auf der spiegelnden Fläche 2 angeordnet sind. Die Dispenstropfen 4 sind beispielweise linienartig angeordnet, so dass die Punktlichtquellen 8 zusammen ein linienförmiges Lichtfeld aufspannen. Figur 12c zeigt auch ein linienförmiges Lichtfeld, für das aber ein einziger streifenförmiger Dispenstropfen 4 eine streifenförmige Lichtquelle 8 erzeugt. Mehrere LED-Chips 3 unter der streifenförmigen Lichtquelle 8 können dabei in Serien- und/oder Reihenschaltung miteinander verschaltet sein. Schließlich zeigt Figur 12d ein flächenförmiges Lichtfeld, das aus mehreren Punktlichtquellen 8 besteht, wobei jede Punktlichtquelle 8 durch einen Dispenstropfen 4 gebildet wird, aufweist. Alle Dispenstropfen 4 sind dabei vorzugsweise auf der spiegelnden Fläche 2 angeordnet.

Für ein LED-Modul 1 mit einem Lichtfeld wie oben beschrieben können bspw. mehrere Punktlichtquellen 8 unterschiedliche optische Eigenschaften aufweisen. Dazu können die optischen Eigenschaften der Dispensmaterialien der einzelnen Dispenstropfen 4 unterschiedlich sein. Bspw. können die Materialien der Dispenstropfen 4 derart gewählt sein, oder derart mit Lichtkonversionsstoffen versetzt sein, dass jede Punktlichtquelle 8 Licht aus einem anderen Lichtspektrum, vorzugsweise einem anderen Farblichtspektrum abgibt. Die einzelnen Lichtspektren der Punktlichtquellen 8 können dann für das Lichtfeld kombiniert werden, so dass von dem LED-Modul 1 ein Mischlicht wie Weißlicht abgegeben wird. Wird ein streifenförmiger Dispenstropfen verwendet, wie in Fig. 12c gezeigt, kann der Dispenstropfen 4 nachträglich auch noch mit Lichtkonversionsstoffen beschichtet werden, die beispielweise entlang seiner Ausdehnungsrichtung verschieden sind und/oder in unterschiedlicher Konzentration aufgebracht sind. Somit kann auch mit einem streifenförmigen Dispenstropfen 4 ein mischlichtabgebendes LED-Modul 1 erzeugt werden.

Vorzugsweise ist vor dem Lichtfeld des LED-Moduls 1, d.h. vor verschiedenen Punktlichtquellen 8 oder vor wenigstens einer streifenförmigen Lichtquelle 8, eine beabstandete Streuscheibe angeordnet. Die Streuscheibe kann Streupartikel enthalten, welche die unterschiedlichen Lichtspektren der mehreren Punktlichtquellen 8 unterschiedlich streuen und dadurch eine Vermischung der Lichtspektren erzielen. Die Streuscheibe kann wiederum Leuchtstoffe oder Lichtkonversionsstoffe aufweisen, um das von den Punktlichtquellen 8 abgegebene Licht auch spektral zu beeinflussen.

Insgesamt stellt die vorliegende Erfindung ein LED-Modul 1 bereit, bei dem ein Dispenstropfen mit einer hochreflektierenden Fläche 2 kombiniert ist. Dadurch kann das LED-Modul 1 kostengünstiger hergestellt werden und gleichzeitig eine hochreflektierende Lösung und ein optimiertes Thermomanagement bieten. Auch LED-Cluster sind durch die vordefinierten spiegelnden Flächen 2 möglich. Ein Vorteil der vorliegenden Erfindung ist, dass mehrere LED-Chips 3, die jeweils gut thermisch angebunden sind, parallel und/oder seriell verschaltet werden können. Auch durch den Einsatz von Standarddispensprozessen können die Kosten des vorliegenden LED-Moduls der vorliegenden Erfindung gesenkt werden.

## Patentansprüche

1. LED-Modul (1), das aufweist:
- eine spiegelnde Fläche (2),
- wenigstens einen LED-Chip (3), der auf der spiegelnden Fläche (2) angeordnet ist, und
- wenigstens einen Dispenstropfen (4), der auf die spiegelnde Fläche (2) aufgebracht ist und den wenigstens einen LED-Chip (3) überdeckt, wobei die Außenkontur der spiegelnden Fläche (2) gleich oder größer als die Außenkontur des Dispenstropfens (4) ist,
wobei unter dem wenigstens einen Dispenstropfen (4) und innerhalb der kreisförmigen Aussenkontur der spiegelnden Fläche (2) ferner wenigstens eine Bondfläche (5) zur Kontaktierung des wenigstens einen LED-Chips (3) mit wenigstens einem Bonddraht (6) angeordnet ist, **dadurch gekennzeichnet dass** die wenigstens eine Bondfläche (5) von außerhalb des wenigstens einen Dispenstropfens (4) und ausserhalb der spiegelnden Fläche durch wenigstens einen elektrisch leitenden Finger (7) kontaktiert ist, welche auf der gleichen Seite des LED-Moduls wie die spiegelnde Fläche angeordnet ist.

2. LED-Modul (1) gemäß Anspruch 1,
wobei die spiegelnde Fläche (2) einen Reflexionsgrad von 94% oder mehr, mehr bevorzugt von 95% oder mehr, besonders bevorzugt von 97% oder mehr aufweist.

3. LED-Modul (1) gemäß einem der Ansprüche 1 oder 2,
wobei unter dem wenigstens einen Dispenstropfen (4) wenigstens ein Bonddraht (6) angeordnet ist.

4. LED-Modul (1) gemäß Anspruch 1 bis 3,
wobei zwei oder mehr elektrisch leitende Finger (7) auf Quadranten der spiegelnden Fläche (2) verteilt sind.

5. LED-Modul (1) gemäß einem der Ansprüche 1 bis 4,
wobei mehrere LED-Chips (3) unter dem wenigstens einen Dispenstropfen (4) angeordnet sind und vorzugsweise dazu ausgelegt sind, unterschiedliche Lichtspektren abzugeben.

6. LED-Modul (1) gemäß Anspruch 5,
wobei die mehreren LED-Chips (3) unter dem Dispenstropfen (4) in einer Serien- und/oder Reihenschaltung mittels der elektrisch leitenden Finger (7) miteinander verschaltet sind.

7. LED-Modul (1) gemäß einem der Ansprüche 1 bis 6,
wobei die Außenkontur der spiegelnde Fläche (2) der Außenkontur des wenigstens einem Dispenstropfens (4) entspricht.

8. LED-Modul (1) gemäß einem der Ansprüche 1 bis 7,
wobei mehrere punktförmige Dispenstropfen (4) auf der spiegelnden Fläche (2) angeordnet sind, um mehrere punktförmige Lichtquellen (8) zu bilden.

9. LED-Modul (1) gemäß Anspruch 8,
wobei die mehreren punktförmigen Lichtquellen (8) ein Lichtfeld aufspannen.

10. LED-Modul (1) gemäß Anspruch 9,
wobei die optischen Eigenschaften des Materials der mehreren Dispenstropfen (4) unterschiedlich sind, um beispielweise unterschiedlich farbige punktförmige Lichtquellen (8) in dem Lichtfeld zu kombinieren.

11. LED-Modul (1) gemäß Anspruch 9 oder 10,
wobei das gesamte Lichtfeld auf der spiegelnden Fläche (2) angeordnet ist.

12. LED-Modul (1) gemäß einem der Ansprüche 9 bis 11,
wobei vor den mehreren punktförmigen Lichtquellen in deren Abstrahlrichtung eine Streuscheibe (10) angeordnet ist.

13. LED-Modul (1) gemäß einem der Ansprüche 1 bis 12,
wobei wenigstens eine Durchkontaktierung um die spiegelnde Fläche (2) herum und außerhalb der Kontur der spiegelnden Fläche (2) angeordnet ist.

14. Verfahren zum Herstellen eines LED-Moduls (1) nach einem der vorhergehenden Ansprüche, wobei das Verfahren die folgenden Schritte aufweist:
- Bilden einer spiegelnden Fläche (2),
- Anordnen von wenigstens einem LED-Chip (3) auf der spiegelnden Fläche (2),
- Anordnen wenigstens einer Bondfläche (5) auf der spiegelnden Fläche (2) und Kontaktierung des wenigstens einen LED-Chips (3) mit wenigstens einem Bonddraht (6),
und
- Überdecken des wenigstens einen LED-Chips (3), der wenigstens einen Bondfläche (5) und des wenigstens einen Bonddrahts (6) mit wenigstens einem Dispenstropfen (4), der auf die spiegelnde Fläche (2) aufgebracht wird,
wobei die Außenkontur der spiegelnden Fläche (2) gleich oder größer als die Außenkontur des Dispenstropfens (4) ist, und
wobei die wenigstens eine Bondfläche (5) von außerhalb des wenigstens einen Dispenstropfens (4) durch wenigstens einen elektrisch leitenden Finger (7) kontaktiert ist, welche auf der gleichen Seite des LED-Moduls wie die spiegelnde Fläche angeordnet ist.

## Claims

1. LED module (1) comprising:
- a reflective surface (2),
- at least one LED chip (3), which is disposed on the reflective surface (2), and
- at least one globe top (4), which is applied to the reflective surface (2) and covers the at least one LED chip (3), wherein the outer contour of the reflective surface (2) is equal to or greater than the outer contour of the globe top (4),
wherein at least one bonding surface (5) for contacting the at least one LED chip (3) with at least one bonding wire (6) is disposed below the at least one globe top (4) and within the circular outer contour of the reflective surface (2), **characterized in that** the at least one bonding surface (5), which is disposed on the same side of the LED module as the reflective surface, is contacted by at least one electrically conductive finger (7) from outside the at least one globe top (4) and outside the reflective surface.

2. LED module (1) according to claim 1,
wherein the reflective surface (2) has a reflectance of 94% or more, more preferably of 95% or more, in particular, preferably of 97% or more.

3. LED module (1) according to one of the claims 1 or 2,
wherein at least one bonding wire (6) is arranged below the at least one globe top (4).

4. LED module (1) according to one of the claims 1 to 3,
wherein two or more electrically conductive fingers (7) are distributed over quadrants of the reflective surface (2).

5. LED module (1 according to one of the claims 1 to 4,
wherein a plurality of LED chips (3) are disposed below the at least one globe top (4) and are configured preferably to emit different light spectra.

6. LED module (1) according to claim 5,
wherein the plurality of LED chips (3) are connected to one another in a series connection and/or series circuit by means of the electrically conductive fingers (7) below the globe top (4).

7. LED module (1) according to one of the claims 1 to 6,
wherein the outer contour of the reflective surface (2) corresponds to the outer contour of the at least one globe top (4).

8. LED module (1) according to one of the claims 1 to 7,
wherein a plurality of point-shaped globe tops (4) are disposed on the reflective surface (2), in order to form a plurality of point-shaped light sources (8).

9. LED module (1) according to in claim 8,
wherein the plurality of point-shaped light sources (8) define a light field.

10. LED module (1) according to claim 9,
wherein the optical properties of the material of the plurality of globe tops (4) vary, in order to combine, for example, different colored point-shaped light sources (8) in the light field.

11. LED module (1) according to claim 9 or 10,
wherein the entire light field is disposed on the reflective surface (2).

12. LED module (1) according to one of the claims 9 to 11,
wherein a diffusion plate (10) is disposed in front of the plurality of point-shaped light sources in the emission direction thereof.

13. LED module (1) according to one of the claims 1 to 12,
wherein at least one via [vertical interconnect access] is arranged around the reflective surface (2) and outside the contour of the reflective surface (2).

14. Method for manufacturing an LED module (1) according to one of the preceding claims, wherein the method comprises the following steps of:
- forming a reflective surface (2),
- disposing at least one LED chip (3) on the reflective surface (2),
- disposing at least one bonding surface (5) on the reflective surface (2) and contacting the at least one LED chip (3) with at least one bonding wire (6),
and
- covering the at least one LED chip (3), the at least one bonding surface (5) and the at least one bonding wire (6) with at least one globe top (4), which is applied to the reflective surface (2),
wherein the outer contour of the reflective surface (2) is equal to or greater than the outer contour of the globe top (4), and
wherein the at least one bonding surface (5) is contacted by at least one electrically conductive finger (7) from outside the at least one globe top (4).

## Revendications

1. Module à DEL (1), qui présente :
- une surface réfléchissante (2),
- au moins une puce à DEL (3), qui est disposée sur la surface réfléchissante (2) et
- au moins un demi globe de distribution (4), qui est rapporté sur la surface réfléchissante (2) et qui recouvre l'au moins une puce à DEL (3), la bordure externe de la surface réfléchissante (2) étant identique ou plus grande que la bordure externe du demi globe de distribution (4),
dans lequel, en dessous de l'au moins un demi globe de distribution (4) et à l'intérieur de la bordure externe circulaire de la surface réfléchissante (2), au moins une surface de connexion (5) est en outre disposée pour l'établissement d'un contact de l'au moins une puce à DEL (3) avec au moins un fil de connexion (6), **caractérisé en ce que**
l'au moins une surface de connexion (5) est en contact depuis l'extérieur de l'au moins un demi globe de distribution (4) et à l'extérieur de la surface réfléchissante par le biais d'au moins un doigt électroconducteur (7), qui est disposé sur le même côté du module à DEL que la surface réfléchissante.

2. Module à DEL (1) selon la revendication 1,
dans lequel la surface réfléchissante (2) présente un facteur de réflexion de 94 % ou plus, plus préférentiellement de 95 % ou plus, de manière particulièrement préférée de 97 % ou plus.

3. Module à DEL (1) selon l'une des revendications 1 ou 2,
dans lequel, en dessous de l'au moins une goutte de distribution (4), au moins un fil de connexion (6) est disposé.

4. Module à DEL (1) selon la revendication 1 à 3
dans lequel deux doigts électroconducteurs (7) ou plus sont répartis sur des quadrants de la surface réfléchissante (2).

5. Module à DEL (1) selon l'une des revendications 1 à 4,
dans lequel plusieurs puces à DEL (3) sont disposées sous l'au moins un demi globe de distribution (4) et sont de préférence conçues pour émettre différents spectres lumineux.

6. Module à DEL (1) selon la revendication 5,
dans lequel les multiples puces à DEL (3) en dessous du demi globe de distribution (4) sont connectées les unes aux autres en un circuit en série et/ou en parallèle au moyen des doigts électroconducteurs (7).

7. Module à DEL (1) selon l'une des revendications 1 à 6,
dans lequel la bordure externe de la surface réfléchissante (2) correspond à la bordure externe de l'au moins un demi globe de distribution (4).

8. Module à DEL (1) selon l'une des revendications 1 à 7,
dans lequel plusieurs demis globes de distribution (4) en forme de points sont disposés sur la surface réfléchissante (2), afin de former plusieurs sources de lumière (8) en forme de points.

9. Module à DEL (1) selon la revendication 8,
dans lequel les multiples sources de lumière (8) en forme de points définissent un champ lumineux.

10. Module à DEL (1) selon la revendication 9,
dans lequel les propriétés optiques du matériau des multiples demis globes de distribution (4) sont différentes, afin, par exemple, de combiner des sources de lumière (8) en forme de points de couleurs différentes dans le champ lumineux.

11. Module à DEL (1) selon la revendication 9 ou 10,
dans lequel le champ lumineux complet est disposé sur la surface réfléchissante (2).

12. Module à DEL (1) selon l'une des revendications 9 à 11,
dans lequel un disque de dispersion (10) est disposé avant les multiples sources de lumière en forme de points dans leur direction de rayonnement.

13. Module à DEL (1) selon l'une des revendications 1 à 12,
dans lequel au moins une interconnexion est disposée autour de la surface réfléchissante (2) et en dehors de la bordure de la surface réfléchissante (2).

14. Procédé de fabrication d'un module à DEL (1) selon l'une des revendications précédentes, où le procédé comprend les étapes suivantes :
- formation d'une surface réfléchissante (2),
- disposition d'au moins une puce à DEL (3) sur la surface réfléchissante (2),
- disposition d'au moins une surface de connexion (5) sur la surface réfléchissante (2) et mise en contact de l'au moins une puce à DEL (3) avec au moins un fil de connexion (6),
Et
- recouvrement de l'au moins une puce à DEL (3), de l'au moins une surface de connexion (5) et de l'au moins un fil de connexion (6) avec au moins un demi globe de distribution (4), qui est appliqué sur la surface réfléchissante (2),
dans lequel la bordure externe de la surface réfléchissante (2) est identique ou plus grande que la bordure externe du demi globe de distribution (4), et dans lequel l'au moins une surface de connexion (5) est mise en contact depuis l'extérieur de l'au moins un demi globe de distribution (4) par le biais d'au moins un doigt électroconducteur (7), qui est disposé sur le même côté du module à DEL que la surface réfléchissante.
